# EUROPEAN PATENT APPLICATION

(11) **EP 4 106 008 A1**
(43) Date of publication of application: **21.12.2022**
(21) Application number: 22159492.2
(22) Date of filing: 01.03.2022
(51) Int. Cl.: H01L 29/78, H01L 27/11502

(54) **THREE-DIMENSIONAL TRANSISTOR ARRANGEMENTS WITH RECESSED GATES**

(30) Priority: 15.06.2021 US 202117347735
(71) Applicant: Intel Corporation, Santa Clara, CA 95054 (US)
(72) Inventor: Sharma, Abhishek A., Hillsboro, 97124 (US); Gomes, Wilfred, Portland, 97229 (US); Kobrinsky, Mauro J., Portland, 97229 (US); Le, Van H., Beaverton, 97007 (US)
(74) Representative: Goddar, Heinz J.

(57) **Abstract**

Described herein are three-dimensional transistors with a recessed gate, and IC devices including such three-dimensional transistors with recessed gates. The transistor includes a channel material (304) having a recess (330). The channel material is formed over a support structure (302), and source/drain regions (312-1, 312-2) are formed in or on the channel material, e.g., one either side of the recess. A gate stack (306, 308) extends through the recess. The distance (342) between the gate stack and the support structure is smaller than the distance (340) between one of the source/drain regions and the support structure. This arrangement increases the channel length relative to prior art transistors, reducing leakage.

## Description

### Technical Field

This disclosure relates generally to the field of integrated circuit (IC) structures and devices, and more specifically, to three-dimensional transistors with recessed gates incorporated in such IC structures and devices.

### Background

Typical fin field-effect transistors (FinFETs) have a fin-shaped channel region with a gate wrapped around the fin, and source and drain regions on either side of the gate. In this design, the channel region between the source and drain extends along a straight line directly under the gate. The arrangement can cause leakage current between the source and drain in the off state of the transistor; this leakage is referred to as subthreshold leakage. Subthreshold leakage reduces device reliability and can have considerable negative effects on power consumption. Particularly in transistors with low threshold voltages to cause transistors to turn, subthreshold leakage can become a significant power drain on the device. Therefore, it is desirable to reduce leakage currents in transistors.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a schematic illustration of a 1T-1C memory cell, according to some embodiments of the present disclosure.
FIG. 2 is a perspective view of an example prior art 1T-1C memory cell arrangement with a typical FinFET.
FIG. 3 is a perspective view of an example three-dimensional transistor with a recessed gate, according to some embodiments of the present disclosure.
FIG. 4 is a cross-sectional view along a plane AA' of the example arrangement shown in FIG. 3, according to some embodiments of the present disclosure.
FIG. 5 is a cross-sectional view along a plane BB' of the example arrangement shown in FIG. 4, according to some embodiments of the present disclosure.
FIG. 6 is a cross-sectional view along a plane CC' of the example arrangement shown in FIG. 4, according to some embodiments of the present disclosure.
FIG. 7 is a perspective view of an alternate embodiment of a three-dimensional transistor with a recessed gate, according to some embodiments of the present disclosure.
FIG. 8 is a perspective view of a further alternate embodiment of a three-dimensional transistor with a recessed gate, according to some embodiments of the present disclosure.
FIG. 9 is a perspective view of an example three-dimensional transistor with a recessed gate and a backside contact, according to some embodiments of the present disclosure.
FIG. 10 provides a schematic illustration of a plurality of 1T-1C memory cells arranged in an array, according to some embodiments of the present disclosure.
FIG. 11 is a perspective view of an example array of 1T-1C memory cells that include three-dimensional transistors with recessed gates, according to some embodiments of the present disclosure.
FIG. 12 is a cross-sectional view along a plane DD' of the example arrangement shown in FIG. 11, according to some embodiments of the present disclosure.
FIG. 13 is an alternate cross-sectional view along the plane DD' of the example arrangement shown in FIG. 11, according to some embodiments of the present disclosure.
FIG. 14 is a perspective view of an example array of 1T-1C memory cells that include three-dimensional transistors with recessed gates and backside contacts coupled to the capacitors, according to some embodiments of the present disclosure.
FIGS. 15A and 15B are top views of a wafer and dies that include one or more three-dimensional transistors with recessed gates in accordance with any of the embodiments disclosed herein.
FIG. 16 is a cross-sectional side view of an IC device that may include one or more three-dimensional transistors with recessed gates in accordance with any of the embodiments disclosed herein.
FIG. 17 is a cross-sectional side view of an IC device assembly that may include one or more three-dimensional transistors with recessed gates in accordance with any of the embodiments disclosed herein.
FIG. 18 is a block diagram of an example computing device that may include one or more three-dimensional transistors with recessed gates in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Described herein are three-dimensional transistors with recessed gates and corresponding methods and devices. The transistor includes a channel material, e.g., a fin-shaped channel material having a longitudinal structure that extends parallel to an upper face of a support structure, e.g., a substrate. The channel material has a recessed portion, so that some part of the channel material extends higher than the recessed portion in a direction away from the support structure. Two source/drain (S/D) regions are formed in or on the channel material. A first S/D region is formed on a portion of the channel material that extends above the recessed portion, relative to the support structure. The second S/D region may be located on another portion of the channel material that extends above the recessed portion, i.e., on the other side of the recessed portion, so that both S/D regions are on a front-side of the channel material. Alternatively, the second S/D region may be located on the side of the channel material closer to the support structure, referred to as the back-side of the channel material.

A gate stack extends over the channel material and through the recessed portion. Unlike a traditional FinFET, where the gate stack is formed over the fin and is higher than the S/D regions relative to the support structure, in the recessed gate structure, the portion of the gate stack extending over the channel portion is closer to the support structure than the first S/D region. In a traditional FinFET, the shortest distance between the two S/D regions is a straight line that extends directly under the gate. Recessing the gate in the channel material extends the distance between the S/D regions, which reduces the leakage current between the S/D regions. For example, if the two S/D regions are both formed on the front-side of the device, the shortest path between the S/D regions is a "U" shape, with the gate stack extending through the center of the "U".

In some embodiments, the gate fills a portion of the recess, leaving a gap between the gate and the first S/D region (and, in some embodiments, the second S/D region). In a typical FinFET structure, the channel region is directly under the gate stack, and the S/D regions are directly next to the gate stack and may extend underneath the gate stack. In this arrangement, the S/D regions may only be separated from the gate electrode by a thin layer of gate oxide, which can lead to higher leakage currents. By contrast, leaving a gap between the gate and the S/D regions helps reduce leakage currents. In other embodiments, the gate may fill the full recess, and in some embodiments, extend above the S/D regions. Extending the gate to the S/D regions reduces contact resistance, which makes it easier to turn on the transistor.

The three-dimensional transistors with recessed gates described herein may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

### Example 1T-1C memory cell

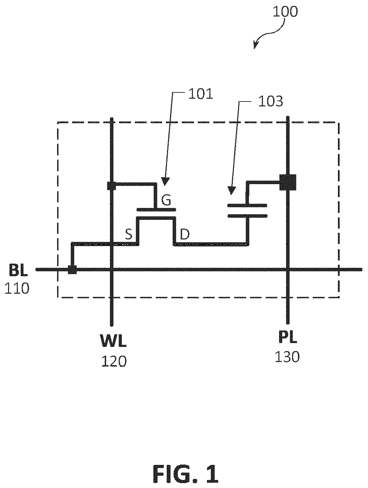

FIG. 1 is a schematic illustration of a 1T-1C memory cell 100 according to some embodiments of the present disclosure. As shown, the 1T-1C memory cell 100 may include an access transistor 101 and a capacitor 103. The access transistor 101 has a gate terminal, a source terminal, and a drain terminal, indicated in the example of FIG. 1 as terminals G, S, and D, respectively.

As shown in FIG. 1, in the 1T-1C memory cell 100, the gate terminal of the access transistor 101 is coupled to a word-line (WL), one of the source or drain terminals of the access transistor 101 is coupled to a bit-line (BL), and the other one of the source or drain terminals of the access transistor 101 is coupled to a first electrode of the capacitor 103. The other electrode of the capacitor 103 is coupled to a plate-line (PL). The WL, BL, and PL are used together to read and program the capacitor 103. In the following, the electrode of the capacitor 103 coupled to the PL is referred to as a "first capacitor electrode" while the electrode of the capacitor 103 coupled to the access transistor is referred to as a "second capacitor electrode."

As is commonly known, source and drain terminals are interchangeable in transistors. Therefore, while the example of FIG. 1 illustrates that the transistor 101 is coupled to the capacitor 103 by its drain terminal, in other embodiments, any one of a source or a drain terminal of the transistor 101 may be coupled to the second electrode of the capacitor 103. A source and a drain terminal of a transistor is sometimes referred to in the following as a "transistor terminal pair" and a "first terminal" of a transistor terminal pair is used to describe, for the access transistor 101, the terminal that is connected to the BL, while a "second terminal" is used to describe the source or drain terminal of the access transistor that is connected to the second capacitor electrode of the capacitor 103.

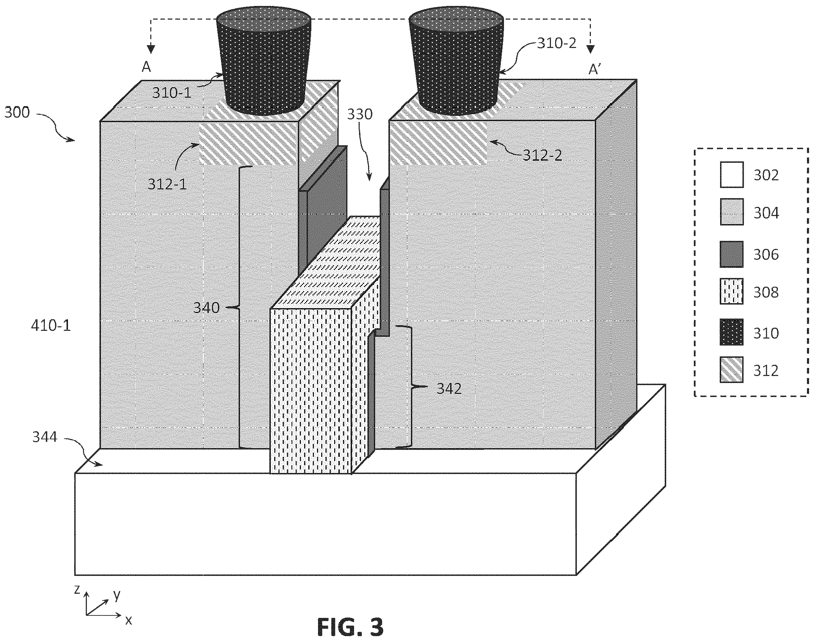

In various embodiments, the access transistor 101 may be any metal oxide semiconductor (MOS) transistors which include drain, source, and gate terminals. In particular embodiments of the present disclosure, the access transistor 101 is a three-dimensional transistor with a recessed gate, such as any of the transistors illustrated in FIGs. 3-9.

### Example memory cell with a FinFET

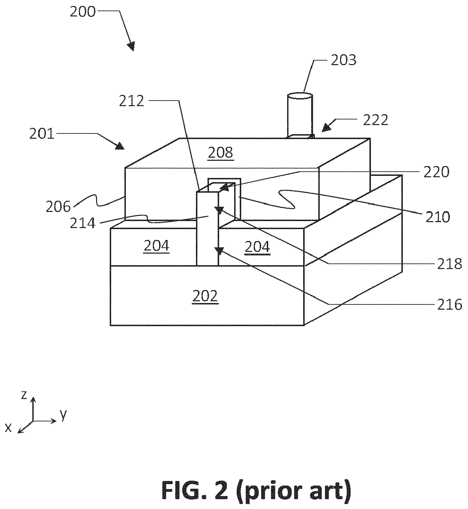

FIG. 2 is a perspective view of an example prior art 1T-1C memory cell arrangement 200 having a FinFET access transistor 201 with a fin 212, and a capacitor 203 coupled to the FinFET 201.

As shown, the FinFET 201 of FIG. 2 includes a base 202, a transistor dielectric material 204, and a gate stack 206 comprising a gate electrode material 208 (which could include a stack of one or more gate electrode materials) and a gate oxide 210 (which could include a stack of one or more gate oxides or other dielectric materials). In the FinFET 201 illustrated in FIG. 2, a fin 212 formed of a semiconductor channel material 214 extends from the base 202.

The transistor dielectric material 204 forms a shallow trench isolation (STI) disposed on either side of the fin 212. A portion of the fin 212 enclosed by the STI 204 forms a sub-fin 216. The STI material 204 may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used in the STI material 204 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

The fin 212 extends away from the base 202 in a direction substantially perpendicular to the base 202. The fin 212 may include one or more semiconductor materials, e.g., a stack of semiconductor materials, so that the upper-most portion 218 of the fin (namely, the portion of the fin 212 enclosed by the gate stack 206) serves as the channel region of the FinFET 201. The gate stack 206 wraps around the fin 212 as shown, with a channel portion 218 corresponding to the portion of the channel material of the fin 212 wrapped by the gate stack 206. In particular, the gate oxide 210 wraps around the channel material 214 of the fin 212, and the gate electrode material 208 wraps around the gate oxide 210. The channel portion 218 ends and the sub-fin portion 216 begins where the gate electrode 208 ends, which is typically where the STI 204 begins.

The fin 212 includes a source region and a drain region 220 and 222 on either side of the gate stack 206, thus realizing a transistor. As is well known in the art, source and drain regions are formed for the gate stack of each MOS transistor. As described above, the source and drain regions of a transistor are interchangeable. The source and drain regions 220/222 of the FinFET 201 may generally be formed using either an implantation/diffusion process or an etching/deposition process.

The FinFET 201 has a gate length (i.e., a distance between the source and drain regions 220 and 222 of the transistor terminal pair of the FinFET 201), a dimension measured along the fin 212, in the direction of the x-axis of an exemplary reference coordinate system x-y-z shown in FIG. 2, which may be between 20 and 40 nanometers. The fin 212 has have a thickness, a dimension measured in the direction of the y-axis of the reference coordinate system x-y-z shown in FIG. 2, that may be between 5 and 30 nanometers. The fin 212 may have a height, a dimension measured in the direction of the z-axis of the reference coordinate system x-y-z shown in FIG. 2, which may be between 30 and 350 nanometers.

While not specifically shown in FIG. 2, S/D contacts may be electrically connected to the source/drain regions 220 and 222. As shown in FIG. 2, the source/drain region 222 of the FinFET 201 is coupled to a capacitor 203, e.g., via the S/D contact connected to the source/drain region 222. In this example, the capacitor 203 is a non-planar (i.e. three-dimensional) capacitor, as shown in FIG. 2 with the capacitor 203 being illustrated as a cylinder.

### Example three-dimensional transistor with recessed gate

In the prior art FinFET 201 in FIG. 2, the channel portion 218 extends straight under the gate stack 206. The shortest path between the source and drain regions 220 and 222 is a straight line directly under the gate oxide 210. Lengthening the path between the source and drain regions 220 and 222, e.g., moving the source and drain regions 220 and 222 further apart, can reduce leakage current. While the transistor arrangement shown in FIG. 2 could be stretched along the x-direction to increase the channel length, this would increase the size of the transistor and, in an IC device consisting of many such transistors, would reduce transistor density across the device, which is undesirable. Furthermore, in the FinFET 201 shown in FIG. 2, the gate oxide 210 is directly in contact with the channel portion 218 along the full length of the channel, with the gate electrode 208 wrapping around the gate oxide 210 and the channel 218, which can lead to additional leakage.

A three-dimensional transistor with a recessed gate provides a longer channel length between a source and drain region while maintaining transistor density across a device. The recessed gate structure results in a longer path between the source and drain regions, which reduces leakage current.

FIG. 3 is a perspective view of an example three-dimensional transistor 300 with a recessed gate, according to some embodiments of the present disclosure. As shown, the transistor 300 is formed on a support structure 302, and the transistor 300 includes a channel material 304, a gate stack comprising a gate dielectric 306 (which could include a stack of one or more gate dielectric materials), and a gate electrode 308 (which could include a stack of one or more gate electrode materials). The channel material 304 has a recess 330, and the gate stack extends through the recess 330. In this example, two source/drain (S/D) regions 312 are formed on either side of the recess 330 and above the gate electrode 308. A pair of contact electrodes 310 are coupled to the S/D regions 312.

A number of elements referred to in the description of FIGs. 3-9 and 10-14 with reference numerals are illustrated in these figures with different patterns, with a legend showing the correspondence between the reference numerals and patterns being provided at the bottom or side of each drawing page containing FIGs. 3-9 and 10-14. For example, the legend in FIG. 3 illustrates that FIG. 3 uses different patterns to show a support structure 302, a channel material 304, a gate dielectric 306, a gate electrode 308, a contact electrode 310, and a S/D region 312.

In general, implementations of the present disclosure may be formed or carried out on a substrate, such as a semiconductor substrate composed of semiconductor material systems including, for example, N-type or P-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. Although a few examples of materials from which the substrate may be formed are described here, any material that may serve as a foundation upon which a semiconductor device may be built falls within the spirit and scope of the present disclosure. In various embodiments the support structure 302 may include any such substrate that provides a suitable surface for providing the transistor 300. In some embodiments, one or more additional layers not shown in FIG. 3 are situated between the support structure 302 and the channel material 304.

In some embodiments, the channel material 304 may be composed of semiconductor material systems including, for example, N-type or P-type materials systems. In some embodiments, the channel material 304 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the channel material 304 may include a combination of semiconductor materials where one semiconductor material may be used for the channel portion, and another material, sometimes referred to as a "blocking material," may be used between the channel portion and the support structure 302 over which the transistor 300 is provided. In some embodiments, the channel material 304 may include a monocrystalline semiconductor, such as silicon (Si) or germanium (Ge). In some embodiments, the channel material 304 may include a compound semiconductor with a first sub-lattice of at least one element from group III of the periodic table (e.g., Al, Ga, In), and a second sub-lattice of at least one element of group V of the periodic table (e.g., P, As, Sb). In some embodiments, the channel material 304 is an epitaxial semiconductor material deposited on the support structure 302 using an epitaxial deposition process. The epitaxial semiconductor material may have a polycrystalline structure with a grain size between about 2 nanometers and 100 nanometers, including all values and ranges therein.

For some example N-type transistor embodiments (i.e., for the embodiments where the transistor 300 is an N-type metal-oxide-semiconductor (NMOS)), the channel material 304 may advantageously include a III-V material having a high electron mobility, such as, but not limited to InGaAs, InP, InSb, and InAs. For some such embodiments, the channel material 304 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). In some embodiments with highest mobility, the channel material 304 may be an intrinsic III-V material, i.e., a III-V semiconductor material not intentionally doped with any electrically active impurity. In alternate embodiments, a nominal impurity dopant level may be present within the channel material 304, for example to further fine-tune a threshold voltage Vt, or to provide HALO pocket implants, etc. Even for impurity-doped embodiments however, impurity dopant level within the channel material 304 may be relatively low, for example below 10¹⁵ dopant atoms per cubic centimeter (cm⁻³), and advantageously below 10¹³ cm⁻³.

For some example P-type transistor embodiments (i.e., for the embodiments where the transistor 300 is a P-type metal-oxide-semiconductor (PMOS)), the channel material 304 may advantageously be a group IV material having a high hole mobility, such as, but not limited to Ge or a Ge-rich SiGe alloy. For some example embodiments, the channel material 304 may have a Ge content between 0.6 and 0.9, and advantageously may be at least 0.7. In some embodiments with highest mobility, the channel material 304 may be intrinsic III-V (or IV for P-type devices) material and not intentionally doped with any electrically active impurity. In alternate embodiments, one or more a nominal impurity dopant level may be present within the channel material 304, for example to further set a threshold voltage (Vt), or to provide HALO pocket implants, etc. Even for impurity-doped embodiments however, impurity dopant level within the channel portion is relatively low, for example below 10¹⁵ cm⁻³, and advantageously below 10¹³ cm⁻³.

In some embodiments, the transistor 300 may be a thin film transistor (TFT). A TFT is a special kind of a field-effect transistor made by depositing a thin film of an active semiconductor material, as well as a dielectric layer and metallic contacts, over a supporting layer that may be a non-conducting layer. At least a portion of the active semiconductor material forms a channel of the TFT. If the transistor 300 is a TFT, the channel material 304 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor 300 is a TFT, the channel material 304 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, Nor P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material 304 may have a thickness between about 5 and 75 nanometers, including all values and ranges therein. In some embodiments, a thin film channel material 304 may be deposited at relatively low temperatures, which allows depositing the channel material 304 within the thermal budgets imposed on back end fabrication to avoid damaging other components, e.g., front end components such as the logic devices.

The channel material 304 has a fin shape that extends away from the support structure 302 in a direction substantially perpendicular to the support structure 302, i.e., perpendicular to the upper face 344 of the support structure 302 and extending in the z-direction in the exemplary reference coordinate system x-y-z shown in FIG. 3. The channel material 304 further has a longitudinal structure extending in a direction parallel to a plane of the support structure 302, e.g., parallel to the upper face 344 of the support structure 302 and extending in the x-direction in the exemplary reference coordinate system x-y-z shown in FIG. 3. The fin may extend further in the x-direction than shown in FIG. 3; for example, many transistors similar to the transistor 300 may be formed along a fin that extends in the x-direction. Channel material 304 for individual transistors may be formed from the fin, e.g., portions of the fin for different transistors may be individuated by patterning and etching the fin, and depositing an interlayer dielectric (ILD) material between the portions.

As shown in FIG. 3, a recess 330 extends into the channel material 304 in the z-direction. The recess 330 does not extend all the way through the channel material 304 in the z-direction, i.e., the recess 330 does not extend down to the support structure 302. The recess 330 extends through the channel material 304 in the y-direction. The recess 330 may be formed in the channel material 304 using an etching process. For example, the channel material 304 may be patterned using any suitable patterning techniques, e.g., photolithographic or electron-beam patterning, possibly in combination with using a mask, e.g., a hardmask, and a suitable etching process is used to remove portions of the channel material 304, e.g., using dry etch, wet etch, reactive ion etch (RIE), ion milling, etc. In some embodiments, an ILD layer (not shown in FIG. 3) is deposited over the patterned channel material 304, and the ILD layer is patterned prior to etching. In such embodiments, the ILD layer is etched, and then the recess 330 in the channel material 304 is etched. In some embodiments, a mask layer is between the channel material 304 and the ILD layer; in such embodiments, the ILD layer is etched, and then the mask layer (which may have been previously patterned) is etched, and then the channel material 304 is etched to form the recess 330.

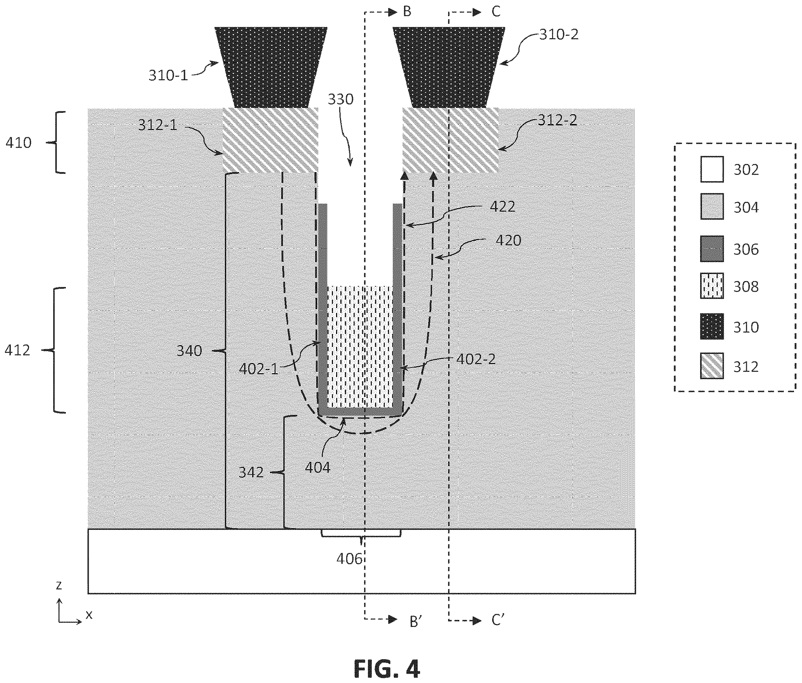

FIG. 4 illustrates a cross-sectional side view in the x-z plane of the example coordinate system x-y-z shown in FIG. 3, with the cross section of FIG. 4 taken across the fin of channel material 304 (e.g., along the plane shown in FIG. 3 as a plane AA'). As shown in FIG. 4, the recess 330 includes two sidewalls 402-1 and 402-2, and a base 404. While the sidewalls 402 and base 404 are illustrated as being at right angles with sharp corners, the cross-sectional shape of the recess 330 may have a different shape, e.g., the base 404 or a portion of the base 404 may be curved, e.g., the base 404 has a semicircular cross section connected to straight sidewalls 402-1 and 402-2, or the recess 330 has a parabolic cross section with a lower portion of the parabola referred to as the base 404 and the upper portions of the parabola referred to as the sidewalls 402

FIG. 4 also illustrates a portion 406 of the channel material 304 is under the recess 330. This portion 406 is situated between the gate stack (specifically, the portion of the gate stack that extends over the channel material 304) and the support structure 302.

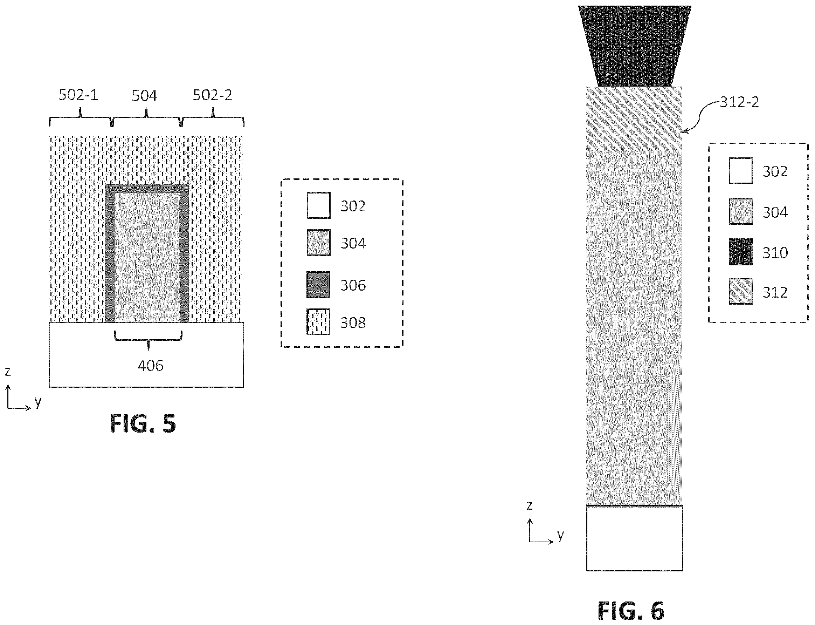

Returning to FIG. 3, the gate stack extends through the recess 330 in the y-direction. The gate stack wraps around the channel material 304, so that one portion of the gate stack on either side of the channel material 304 is directly over the support structure 302, without the channel material 304 between these portions of the gate stack and the support structure 302. FIG. 5 illustrates a cross-sectional view in the y-z plane of the example coordinate system shown in FIG. 3, with the cross section taken along the gate stack (e.g., along the plane shown in FIG. 4 as a plane BB'). FIG. 5 illustrates three portions of the gate stack: two portions 502-1 and 502-2 on either side of the channel material 304, and another portion 504 over the portion 406 of the channel material described above and illustrated in the x-z plane in FIG. 4. The portion 504 of the gate stack extending over the portion 406 of the channel material 304 is situated in the recess 330.

The gate stack includes a gate dielectric 306 and a gate electrode 308. In some embodiments, the gate dielectric 306 may include one or more high-k dielectrics. Examples of high-k materials that may be used in the gate dielectric 306 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. The gate dielectric 306 may be deposited using a conformal deposition process, such as atomic layer deposition (ALD) or chemical vapor deposition (CVD). Conformal deposition generally refers to deposition of a certain coating on any exposed surface of a given structure. A conformal coating may, therefore, be understood as a coating that is applied to exposed surfaces of a given structure, and not, for example, just to the horizontal surfaces. In some embodiments, an annealing process may be carried out on the gate dielectric 306 during manufacture of the transistor 300 to improve the quality of the gate dielectric 306. The gate dielectric 306 may have a thickness, a dimension measured in the direction of the y-axis of the reference coordinate system x-y-z shown in FIG. 3, that may, in some embodiments, be between 0.5 nanometers and 20 nanometers, including all values and ranges therein (e.g., between 2 and 6 nanometers).

The gate electrode 308 may include at least one P-type work function metal or N-type work function metal, depending on whether the transistor 300 is a PMOS transistor or an NMOS transistor (P-type work function metal used as the gate electrode 308 when the transistor 300 is a PMOS transistor and N-type work function metal used as the gate electrode 308 when the transistor 300 is an NMOS transistor). For a PMOS transistor, metals that may be used for the gate electrode 308 may include, but are not limited to, ruthenium, palladium, platinum, cobalt, nickel, and conductive metal oxides (e.g., ruthenium oxide). For an NMOS transistor, metals that may be used for the gate electrode 308 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 308 may consist of a stack of two or more metal layers, where one or more metal layers are work function metal layers and at least one metal layer is a fill metal layer. Further layers may be included next to the gate electrode 308 for other purposes, such as to act as a diffusion barrier layer or/and an adhesion layer.

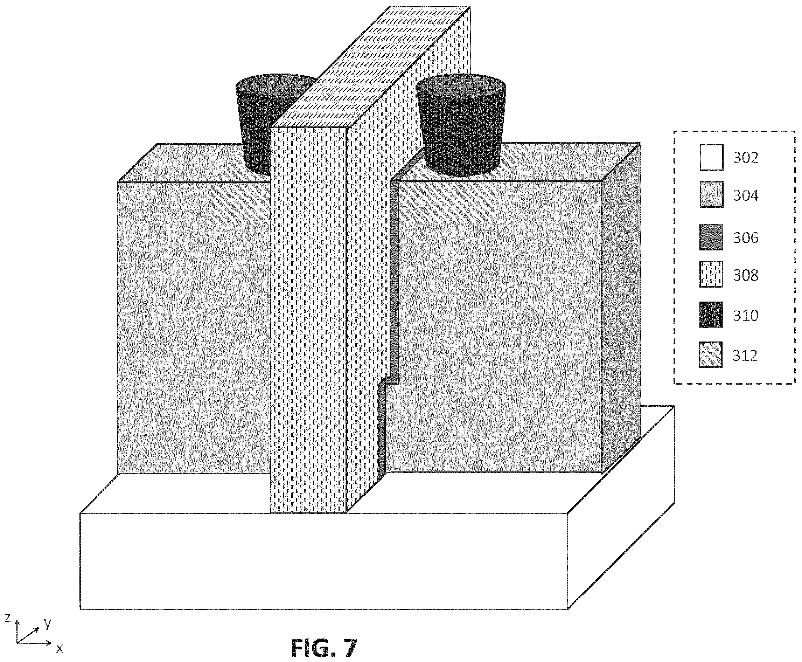

In the example shown in FIGs. 3-5, the gate stack extends partway up the recess 330, with a gap between the top of the gate stack and the top of the channel material 304. As illustrated in FIG. 4, the gate dielectric 306 is deposited along the base 404 and along a portion of each of the two sidewalls 402-1 and 402-2. The gate electrode 308 is deposited within the recess 330, with the gate dielectric 306 between the gate electrode 308 and the channel material 304. In the example of FIGs. 3-5, the gate dielectric 306 extends up the sidewalls 402-1 and 402-2 in the z-direction towards the S/D regions 312, but not reaching the S/D regions 312. The gate electrode 308 and gate dielectric 306 may have different heights, and different relative heights in the z-direction, than the example shown in FIGs. 3 and 4 as long as the gate dielectric 306 is between the gate electrode 308 and the channel material 304, so that the gate electrode 308 is not in contact with the channel material 304 and/or S/D regions 312. For example, the gate dielectric 306 and gate electrode 308 may both extend in the z-direction up to the base of the S/D regions 312. In another example, the gate dielectric 306 and gate electrode 308 extend along the full length of the sidewalls 402 to a top face of the channel material 304. In some embodiments, the gate electrode 308 further extends above the top face of the channel material 304. An example where the gate electrode 308 extends above the channel material 304 is shown in FIG. 7.

Returning to FIG. 3, two S/D regions 312-1 and 312-2 (together referred to as "S/D regions 312") are situated on either side of the recess 330, along the top of the channel material 304. Two S/D contact electrodes 310-1 and 310-2 (together referred to as "contact electrodes 310" or "S/D contact electrodes 310"), formed of one or more electrically conductive materials, may be used for providing electrical connectivity to the S/D regions 312-1 and 312-2, respectively. FIG. 6 illustrates a second cross-sectional view in the y-z plane of the example coordinate system shown in FIG. 3, with the cross section taken along the second S/D region 312-2 and S/D contact electrode 310-2 (e.g., along the plane shown in FIG. 4 as a plane CC').

The S/D regions 312 may generally be formed using either an implantation/diffusion process or an etching/deposition process. In the former process, dopants such as boron, aluminum, antimony, phosphorous, or arsenic may be ion-implanted into the channel material to form the source and drain regions. An annealing process that activates the dopants and causes them to diffuse further into the channel material 304 typically follows the ion implantation process. In the latter process, the channel material 304 may first be etched to form recesses at the locations of the source and drain regions. An epitaxial deposition process may then be carried out to fill the recesses with material that is used to fabricate the source and drain regions. In some implementations, the S/D regions 312 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 312 may be formed using one or more alternate semiconductor materials such as germanium or a group III-V material or alloy. And in further embodiments, one or more layers of metal and/or metal alloys may be used to form the S/D regions 312.

In various embodiments, one or more layers of metal and/or metal alloys may be used to form the S/D contact electrodes 310. For example, the electrically conductive materials of the S/D contact electrodes 310 may include one or more metals or metal alloys, with materials such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. In some embodiments, the S/D contact electrodes 310 may include one or more electrically conductive alloys, oxides, or carbides of one or more metals. In some embodiments, the S/D contact electrodes 310 may include a doped semiconductor, such as silicon or another semiconductor doped with an N-type dopant or a P-type dopant. Metals may provide higher conductivity, while doped semiconductors may be easier to pattern during fabrication. Although FIG. 3 illustrates the first and second S/D contact electrodes 310 with a single pattern, suggesting that the material composition of the first and second S/D contact electrodes 310 is the same, this may not be the case in some other embodiments of the transistor 300. Thus, in some embodiments, the material composition of the first S/D contact electrode 310-1 may be different from the material composition of the second S/D contact electrode 310-2.

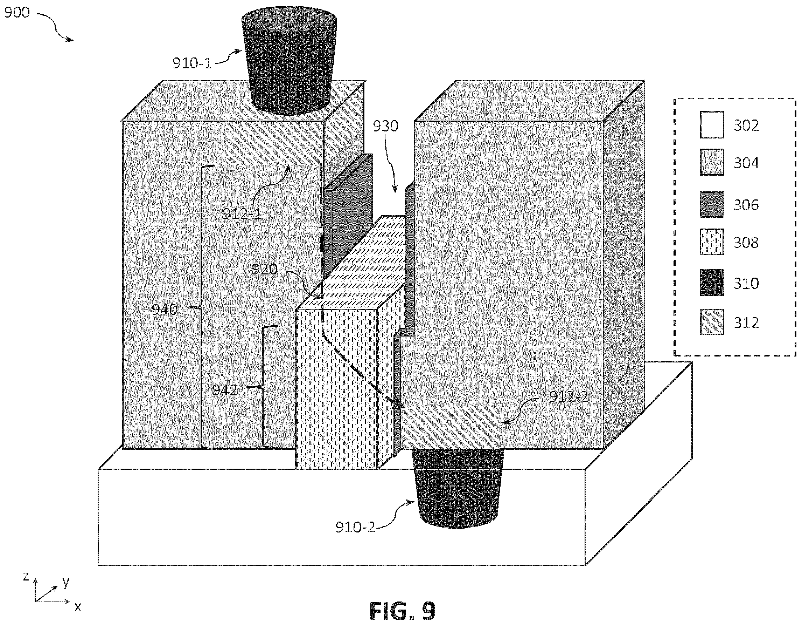

As shown in FIG. 4, the S/D regions 312 are located in one layer 410 of the device, above a second layer 412 of the device that includes the portion 504 of the gate stack extending over the portion 406 of the channel material. Both layers 410 and 412 are over the support structure 302, and the second layer 412 is situated between the support structure 302 and the first layer 410. In an alternate embodiment, one of the S/D regions may be formed on the backside, and coupled to a backside contact. An example of such an embodiment is shown in FIG. 9.

FIGs. 3 and 4 illustrate two distances 340 and 342, where the first distance 340 is a distance from the first S/D region 312-1 and the support structure 302, and the second distance 342 is a distance from the portion of the gate stack situated over the channel material 304 (i.e., the portion 504 of the gate stack) to the support structure 302. The second distance 342 is smaller than the first distance 340, i.e., the distance from the support structure 302 to the portion of the gate stack over the channel material is smaller than the distance from the support structure 302 to the first S/D region 312-1. In this example, with two front-side contacts, the distance from the second S/D region 312-2 to the support structure 302 is the same as the first distance 340. The first distance 340 may have a length between about 20 nanometers to 400 nanometers, including all values and ranges therein, e.g., between about 40 nanometers and 60 nanometers. The second distance 342 may have a length between about 3 nanometers to 100 nanometers, including all values and ranges therein, e.g., between about 3 nanometers and 10 nanometers.

FIG. 4 further illustrates two example paths 420 and 422 between the S/D regions 312-1 and 312-2. The paths 420 and 422 are example current pathways between the S/D regions 312. The path 420 may represent a typical path, extending down from the first S/D region, around the recess 330, and up to the second S/D region 312-2. The path 422 represents a shortest path between the two S/D regions 312, extending from the first S/D region 312-1 down the first sidewall 402-1, across the base 404, up the second sidewall 402-2, and to the second S/D region 312-2. The direction of current may be the opposite of the direction shown in FIG. 4, i.e., current may alternatively travel from the second S/D region 312-2 to the first S/D region 312-1.

As illustrated in FIG. 4, the paths 420 and 422, and in particular, the shortest path 422, is not a straight line. Instead, the shortest path 422 has a "U" shape that extends around the recess 330. This is in contrast to the shortest path of the FinFET 200, which is a straight line directly under the gate oxide 210.

The arrangement shown in FIG. 3 (and other figures of the present disclosure) is intended to show relative arrangements of some of the components therein, and that the arrangement with the transistor 300, or portions thereof, may include other components that are not illustrated. For example, although not specifically illustrated in FIG. 3, a dielectric spacer may be provided between one or both of the S/D contact electrodes 310 and the gate electrode 308 in order to provide additional electrical isolation between the source, gate, drain electrodes. In another example, although not specifically illustrated in FIG. 3, at least portions of the transistor 300 may be surrounded in an insulator material, such as any suitable ILD material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 300 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

### Additional examples of three-dimensional transistor with recessed gate and front-side contacts

FIG. 7 is a perspective view of an alternate embodiment of a three-dimensional transistor with a recessed gate, according to some embodiments of the present disclosure. The legend illustrates that FIG. 7 uses different patterns to show the same set of materials shown in FIGs. 3-6, i.e., the support structure 302, the channel material 304, the gate dielectric 306, the gate electrode 308, the contact electrodes 310, and the S/D regions 312.

In the example shown in FIG. 7, rather than the gate dielectric 306 and gate electrode 308 extending partway up the recess 330, as shown in FIG. 3, the gate dielectric 306 extends up the full length of the sidewalls of the recess. The gate dielectric 306 is deposited along the recessed portion of the channel material 304 and the sides of the S/D regions 312. In this example, the gate electrode 308 extends above the channel material 304 in the z-direction, and even higher than the contact electrodes 310. The gate electrode 308 may alternatively be taller or shorter than shown in FIG. 7.

As noted above, in the example shown in FIG. 3, there is a gap in the z-direction between the top of the gate electrode 308 and the S/D regions 312. In the example shown in FIG. 7, there is no such gap; instead, the gate electrode 308 extends upwards to and, in this case, above the S/D regions 312. The height of the gate electrode 308 relative to the height of the S/D regions 312 can be modulated to achieve different transistor properties. For example, having a larger gap between the gate electrode 308 and S/D regions 312, such as the gap shown in FIG. 3, results in less leakage current. However, this arrangement increases contact resistance, making it more difficult to turn the transistor on and have current flow between the S/D regions 312. By contrast, having a smaller gap, or no gap at all (as shown in FIG. 7) improves contact resistance, but can lead to higher leakage current than the arrangement shown in FIG. 3.

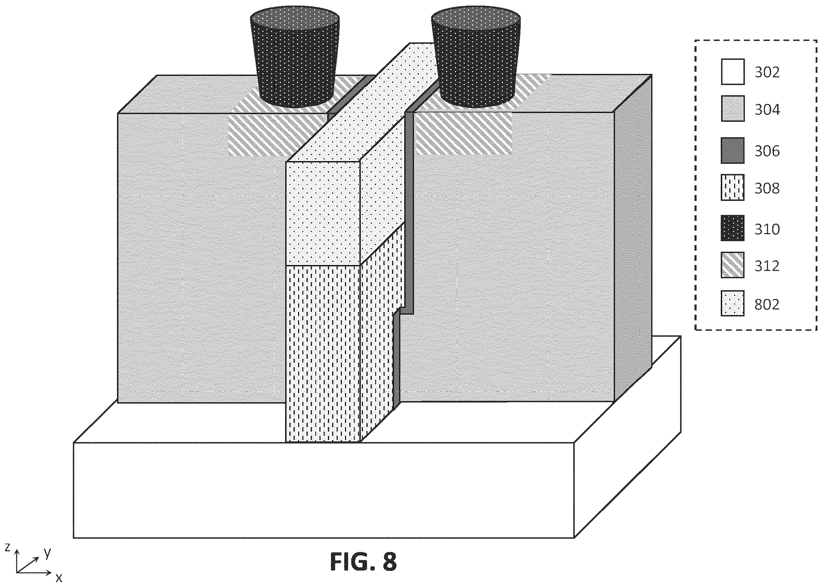

FIG. 8 is a perspective view of a further alternate embodiment of a three-dimensional transistor with a recessed gate, according to some embodiments of the present disclosure. The legend illustrates that FIG. 8 uses different patterns to show the same set of materials shown in FIGs. 3-6, i.e., the support structure 302, the channel material 304, the gate dielectric 306, the gate electrode 308, the contact electrodes 310, and the S/D regions 312. The legend further includes an insulator material 802 above the gate electrode 308 and within the recess. The insulator material 802 may be any of the insulator/dielectric materials described above.

In the example shown in FIG. 8, the gate electrode 308 extends partway up the recess 330, similar to the gate electrode 308 shown in FIG. 3. The insulator material 802 is deposited over top of the gate electrode 308, reaching the top of the channel material 304. In other embodiments, the insulator material 802 may extend higher, e.g., above the channel material 304, or lower, e.g., below the channel material 304. The insulator material 802 reduces capacitance between the contact electrodes 310 and the gate electrode 308. In this example, the gate dielectric 306 extends up the full length of the sidewalls of the recess. In other embodiments, the gate dielectric 306 may extend partially up the sidewalls, as long as the gate dielectric 306 separates the gate electrode 308 from the channel material 304.

### Example three-dimensional transistor with recessed gate and backside contact

FIG. 9 is a perspective view of an example three-dimensional transistor with a recessed gate and a backside contact, according to some embodiments of the present disclosure. The legend illustrates that FIG. 9 uses different patterns to show the same set of materials shown in FIGs. 3-6, i.e., the support structure 302, the channel material 304, the gate dielectric 306, the gate electrode 308, the contact electrodes 310, and the S/D regions 312.

The transistor 900 includes two S/D regions 912-1 and 912-2 formed from the S/D material 312 coupled to two contact electrodes 910-1 and 910-2 formed from the contact electrode material 310. The first contact electrode 910-1 is a front-side contact, similar to the contact electrode 310-1 shown in FIG. 3. The second contact electrode 910-2 is a backside contact, coupled to an S/D region 912-2 formed on the back-side of the channel material 304, i.e., the side closer to the support structure 302. The first S/D region 912-1 is in a first layer over the support structure 302, i.e., the same layer 410 shown in FIG. 4. The portion of the gate stack (i.e., the gate dielectric 306 and gate electrode 308) over the portion of the channel material 304 under the recess is in a second layer over the support structure 302, i.e., the same layer 412 shown in FIG. 4. Unlike the example shown in FIG. 4, the second S/D region 912-2 is not in the first layer 410, but rather in a third layer over the support structure 302 that is between the second layer and the support structure 302, and the second layer having the gate stack is between the first layer (the layer of the first S/D region 912-1) and the third layer (the layer of the second S/D region 912-2).

FIG. 9 illustrates two distances 940 and 942, where the first distance 940 is a distance from the S/D region 912-1 and the support structure 302, and the second distance 942 is a distance from the portion of the gate stack situated over the channel material 304 to the support structure 302. The first distance 940 is similar to the distance 340, and the first distance 940 may be within the ranges described with respect to the distance 340. The second distance 942 is similar to the distance 342, and the second distance 942 may be within the ranges described with respect to the distance 342. As describe with respect to FIG. 3, the second distance 942 is smaller than the first distance 940, i.e., the distance from the support structure 302 to the portion of the gate stack over the channel material is smaller than the distance from the support structure 302 to the first S/D region 912-1.

FIG. 9 also illustrates an example path 920 between the S/D regions 912-1 and 912-2. The path 920 is an example current pathway between the S/D regions. The path 920 represents a shortest path between the two S/D regions 912, extending from the first S/D region 912-1 down a sidewall of the recess (similar to the first sidewall 402-1), and diagonally from the lower-left corner of the recess to the second S/D region 912-2. The direction of current may be the opposite of the direction shown in FIG. 9, i.e., current may alternatively travel from the second S/D region 912-2 to the first S/D region 912-1. As illustrated in FIG.9, the shortest path 920 is not a straight line. Instead, the shortest path 920 travels in down the sidewall and then bends under the recess. This is in contrast to the shortest path of the FinFET 200, which is a straight line directly under the gate oxide 210. A back-side contact FinFET, in which the gate is not recessed (as it is in FIG. 9), typically has a shortest path between the S/D regions that is a straight, diagonal line through the channel material.

### Example 1T-1C memory array

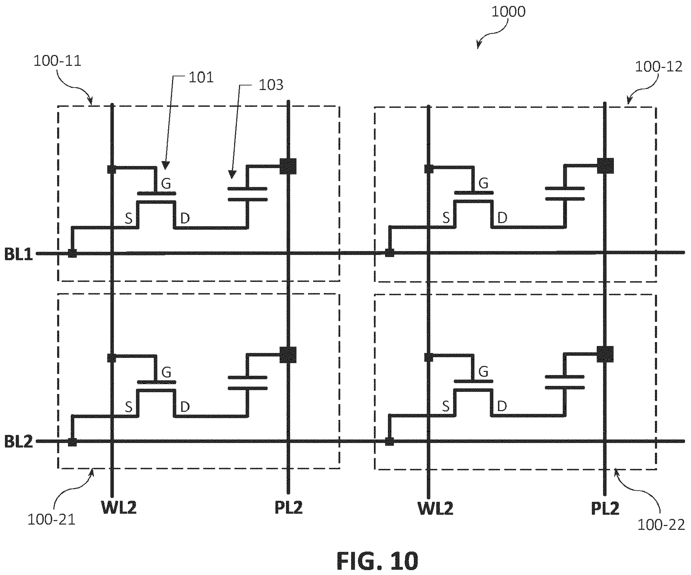

FIG. 10 provides a schematic illustration of a plurality of 1T-1C memory cells, namely four cells, arranged in an array 1000, according to some embodiments of the present disclosure. Each memory cell shown in FIG. 10 could be any one of the 1T-1C memory bit-cells as described herein, and may include a three-dimensional transistor with a recessed gate. While only four such memory cells are shown in FIG. 10, in other embodiments, the array 1000 may, and typically would, include many more memory cells. Furthermore, in other embodiments, the 1T-1C memory cells as described herein may be arranged in arrays in other manners as known in the art, all of which being within the scope of the present disclosure.

FIG. 10 illustrates that BL can be shared among multiple memory cells 100 in a column (each 1T-1C memory cell 100 as described herein illustrated in FIG. 10 to be within a dashed box labeled 100-11, 100-12, 100-21, and 100-22), and that WL and PL can be shared among multiple memory cells 100 in a row. As is conventionally used in context of memory, the terms "row" and "column" do not reflect the, respectively, horizontal and vertical orientation on a page of a drawing illustrating a memory array but, instead, reflect on how individual memory cells are addressed. Namely, memory cells 100 sharing a single BL are said to be in the same column, while memory cells sharing a single WL are said to be on the same row. Thus, in FIG. 10, the horizontal lines refer to columns while vertical lines refer to rows. Different instances of each line (BL, WL, and PL) are indicated in FIG. 10 with different reference numerals, e.g. BL1 and BL2 are the two different instances of the BL as described herein. The same reference numeral on the different lines WL and PL indicates that those lines are used to address/control the memory cells in a single row, e.g. WL1 and PL1 are used to address/control the memory cells 100 in row 1, and so on. Each memory cell 100 may then be addressed by using the BL corresponding to the column of the cell and by using the WL and PL corresponding to the row of the cell. For example, the memory cell 100-11 is controlled by BL1, WL1, and PL1, the memory cell 100-12 is controlled by BL1, WL2, and PL2, and so on.

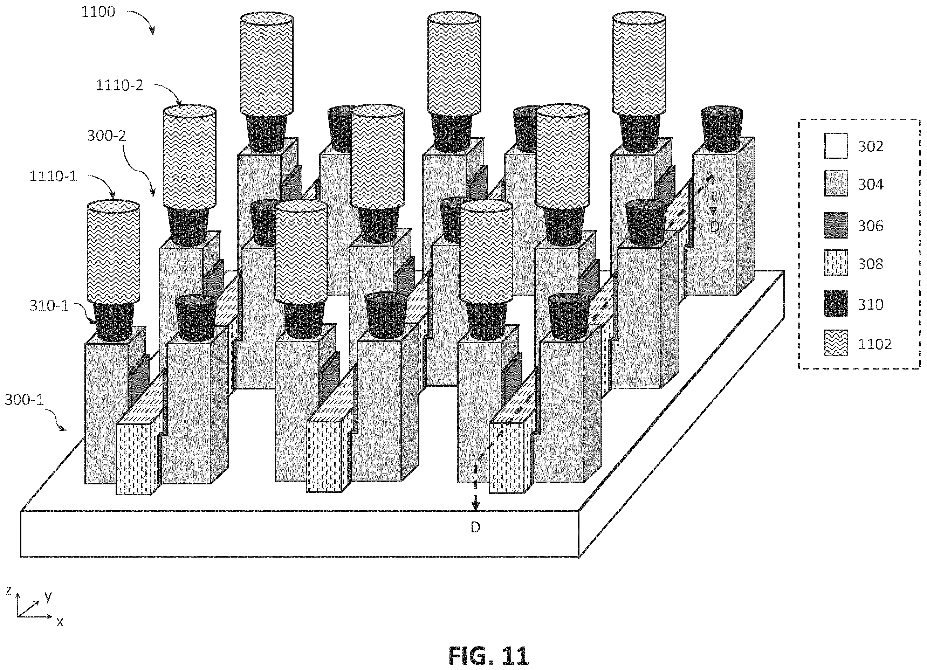

FIG. 11 is a perspective view of an example array 1100 of 1T-1C memory cells that include three-dimensional transistors with recessed gates, according to some embodiments of the present disclosure. The array 1100 is an example implementation of the array 1000 shown in FIG. 10, with nine example 1T-1C memory cells arranged in rows and columns (here, three rows and three columns). Each of the memory cells includes the transistor 300 shown in FIG. 3, and a capacitor 1110 represented in the legend with the pattern 1102. The legend further shows the materials 302-310 shown in FIG. 3; in this example, the S/D regions 312 are not specifically shown.

For example, a first memory cell includes a first transistor 300-1 coupled to a first capacitor 1110-1, and a second memory cell includes a second transistor 300-2 coupled to a second capacitor 1110-2. The capacitors 1110 are each coupled to the first contact electrode of the corresponding transistor; e.g., the capacitor 1110-1 is coupled to the first contact electrode 310-1 of the first transistor 300-1. The capacitors 1110 are further coupled to a PL, as shown in FIG. 10; the PL is omitted from FIG. 11. The second contact electrode of each transistor 300 is coupled to a BL, as shown in FIG. 10; the BL is also omitted from FIG. 11. The BLs connect transistors along the x-direction in the orientation of FIG. 11. In alternate embodiments, the capacitors 1110 may be coupled to the second contact electrodes 310-2 and the BLs coupled to the first contact electrodes 310-1.

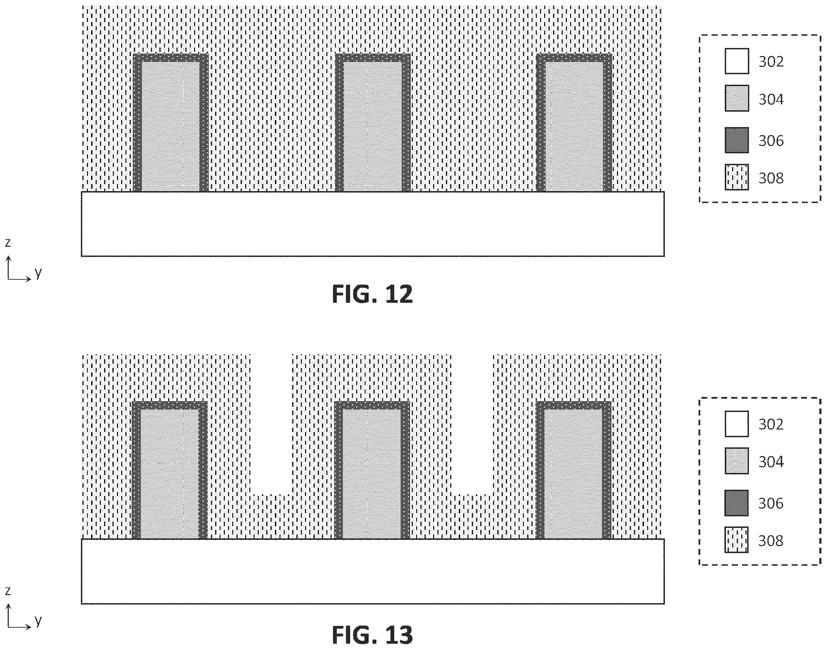

The gate electrodes 308 extend in the y-direction in the orientation of FIG. 11, forming a WL. For example, the gate electrode 308 of the first transistor 300-1 extends in the y-direction to the gate electrode 308 of the second transistor 300-2. Each WL is also coupled to one or more WL contacts (not shown) to apply signals to the WL. Two example cross-sectional views along the plane DD' are shown in FIGs. 12 and 13, which illustrate how the gate electrode extends across multiple transistors to form a WL.

FIG. 12 is a cross-sectional view along the plane DD' of the example arrangement shown in FIG. 11, according to some embodiments of the present disclosure. In this example, the gate electrode 308 fills the regions between adjacent transistors, so that the top of the gate electrode 308 is planar. The gate electrode 308 may be deposited using any deposition process described above, and may be smoothed along the top to form the top surface shown in FIG. 12.

FIG. 13 is an alternate cross-sectional view along the plane DD' of the example arrangement shown in FIG. 11, according to some embodiments of the present disclosure. In this example, the gate electrode 308 extends a consistent distance in the y-direction and z-direction, with the gate electrode 308 following the pattern of the portions 406 of the channel material 304 along the support structure 302. The gate electrode 308 may be deposited using any deposition process described above, e.g., using a conformal deposition process.

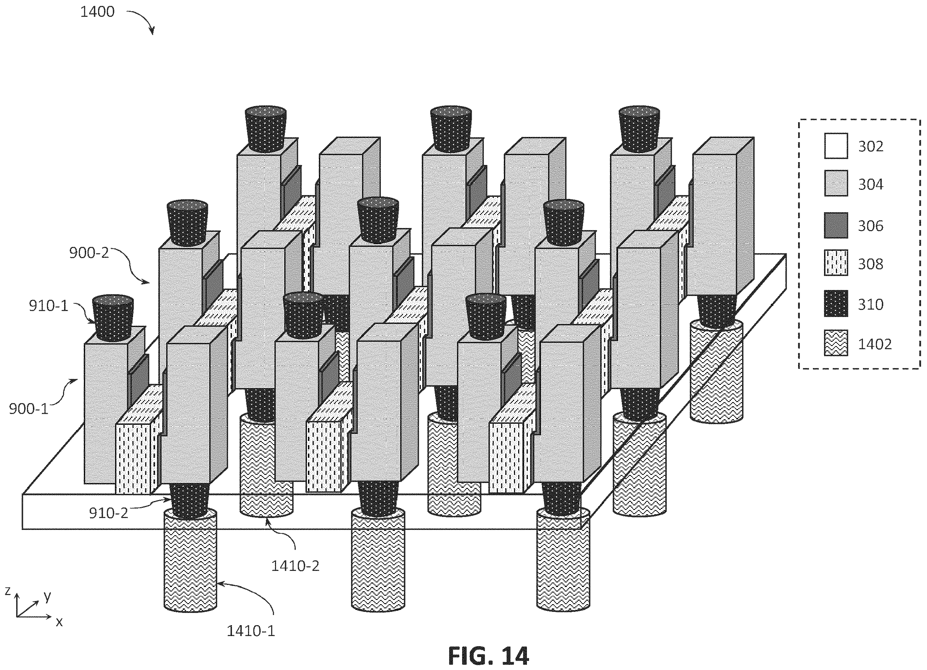

FIG. 14 is a perspective view of an example array of 1T-1C memory cells that include three-dimensional transistors with recessed gates and backside contacts coupled to the capacitors, according to some embodiments of the present disclosure. The array 1400 is an example implementation of the array 1000 shown in FIG. 10, with nine example 1T-1C memory cells arranged in rows and columns (here, three rows and three columns). Each of the memory cells includes the transistor 900 shown in FIG. 9, and a capacitor 1410 represented in the legend with the pattern 1402. The legend further shows the materials 302-310 shown in FIGs. 3 and 9; in this example, the S/D regions 912 are not specifically shown.

For example, a first memory cell includes a transistor 900-1 coupled to a capacitor 1410-1, and a second memory cell includes a transistor 900-2 coupled to a capacitor 1410-2. The capacitors 1410 are each coupled to the second contact electrode of the corresponding transistor; e.g., the capacitor 1410-1 is coupled to the second contact electrode 910-2 of the first transistor 900-1. The capacitors 1410 extend into the support structure 302, or the second contact electrode 910-2 may extend through the support structure 302, with the capacitors 1410 formed in a layer below the support structure 302. The capacitors 1410 are further coupled to a PL, as shown in FIG. 10; the PL is omitted from FIG. 14. The second contact electrode of each transistor 900 is coupled to a BL, as shown in FIG. 10; the BL is also omitted from FIG. 14. The BLs connect transistors along the x-direction in the orientation of FIG. 14. The gate electrodes 308 extend in the y-direction in the orientation of FIG. 14, forming a WL, as described with respect to FIGs. 11-13. In alternate embodiments, the capacitors 1410 may be coupled to the first contact electrodes 910-1 and the BLs coupled to the second contact electrodes 910-2.

### Example devices

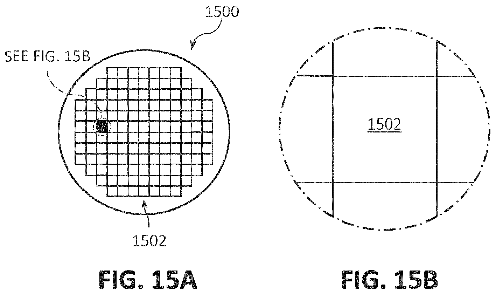

The three-dimensional transistors with recessed gates disclosed herein may be included in any suitable electronic device. FIGS. 15-18 illustrate various examples of apparatuses that may include one or more of the three-dimensional transistors with recessed gates disclosed herein.

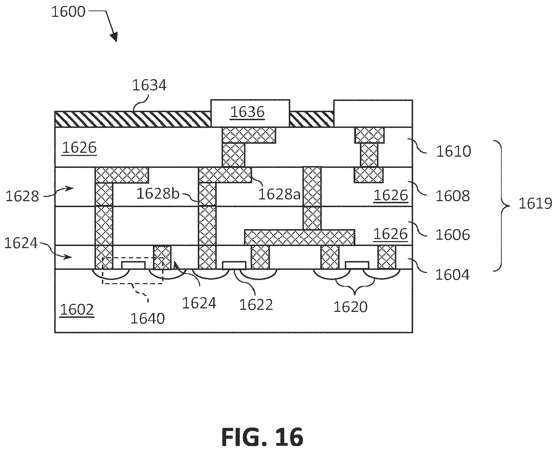

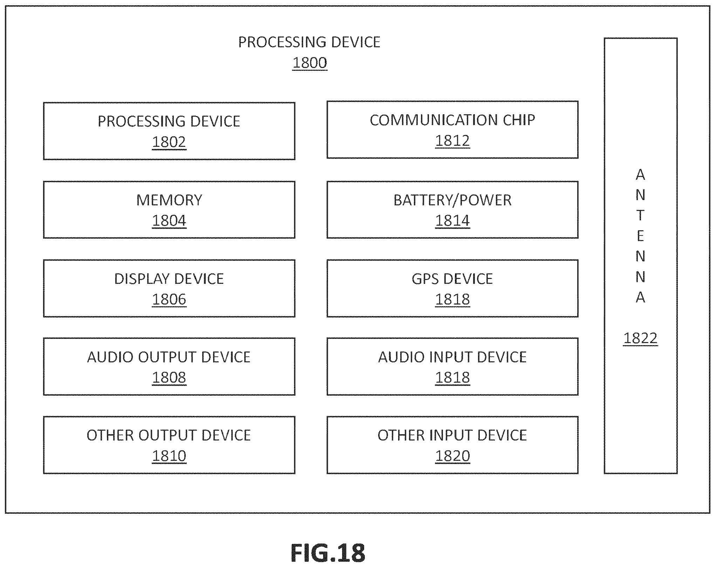

FIGS. 15A and 15B are top views of a wafer and dies that include one or more IC structures with one or more three-dimensional transistors with recessed gates in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 3-14, or any further embodiments of the IC structures described herein). After the fabrication of the semiconductor product is complete (e.g., after manufacture of one or more IC structures with one or more three-dimensional transistors with recessed gates as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more IC structures with one or more three-dimensional transistors with recessed gates as disclosed herein may take the form of the wafer 1500 (e.g., not singulated) or the form of the die 1502 (e.g., singulated). The die 1502 may include one or more transistors (e.g., one or more of the transistors 1640 of FIG. 16, discussed below) and/or supporting circuitry to route electrical signals to the transistors, as well as any other IC components (e.g., one or more IC structures with one or more three-dimensional transistors with recessed gates). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 18) or other logic that is configured to store information in the memory devices or execute instructions stored in the memory array.

FIG. 16 is a cross-sectional side view of an IC device 1600 that may include one or more IC structures with one or more three-dimensional transistors with recessed gates in accordance with any of the embodiments disclosed herein. The IC device 1600 may be formed on a substrate 1602 (e.g., the wafer 1500 of FIG. 15A) and may be included in a die (e.g., the die 1502 of FIG. 15B). The substrate 1602 may be any substrate as described herein. The substrate 1602 may be part of a singulated die (e.g., the dies 1502 of FIG. 15B) or a wafer (e.g., the wafer 1500 of FIG. 15A).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 16 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

Although not specifically shown in FIG. 16, the IC device 1600 may include one or more three-dimensional transistors with recessed gates at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 16 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 16). Although a particular number of interconnect layers 1606-1610 is depicted in FIG. 16, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 16. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 16. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

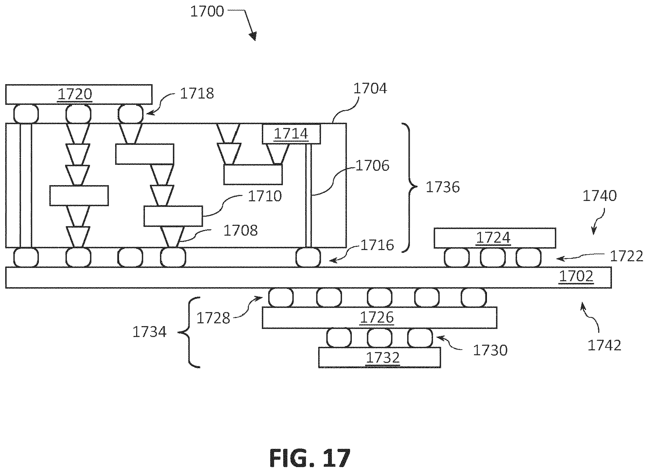

FIG. 17 is a cross-sectional side view of an IC device assembly 1700 that may include components having or being associated with (e.g., being electrically connected by means of) one or more IC structures with three-dimensional transistors with recessed gates in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include any of the three-dimensional transistors with recessed gates, disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 17 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 17), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 17, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 15B), an IC device (e.g., the IC device 1600 of FIG. 16), or any other suitable component. In some embodiments, the IC package 1720 may include one or more three-dimensional transistors with recessed gates, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 17, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The interposer 1704 may further include one or more three-dimensional transistors with recessed gates, as described herein. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 17 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 18 is a block diagram of an example computing device 1800 that may include one or more components including one or more IC structures with one or more three-dimensional transistors with recessed gates in accordance with any of the embodiments disclosed herein. For example, any suitable ones of the components of the computing device 1800 may include a die (e.g., the die 1502 of FIG. 15B) having one or more three-dimensional transistors with recessed gates as described herein. Any one or more of the components of the computing device 1800 may include, or be included in, an IC device 1600 (FIG. 16). Any one or more of the components of the computing device 1800 may include, or be included in, an IC device assembly 1700 (FIG. 17).

A number of components are illustrated in FIG. 18 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 18, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808 but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1808 (or corresponding interface circuitry, as discussed above). The audio output device 1808 may include any device that generates an audible indicator, such as speakers, headsets, or earbuds, for example.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides an IC device that includes a support structure having an upper face; a channel material having a longitudinal structure extending in a direction parallel to the upper face of the support structure; a first S/D region at a first distance from the support structure; a second S/D region; and a gate stack having a portion over a portion of the channel material so that the portion of the channel material is between the portion of the gate stack and the support structure, where the portion of the gate stack over the portion of the channel material is at a second distance from the support structure, the second distance being smaller than the first distance.

Example 2 provides the IC device of example 1, further including a first contact coupled to the first S/D region and a second contact coupled to the second S/D region.

Example 3 provides the IC device of example 1 or 2, where the first S/D region and the second S/D region are in a first layer over the support structure, the portion of the gate stack over the portion of the channel material is in a second layer over the support structure, and the second layer is between the support structure and the first layer.

Example 4 provides the IC device of example 1 or 2, where the first S/D region is in a first layer over the support structure, the portion of the gate stack over the portion of the channel material is in a second layer over the support structure, the second S/D region is in a third layer over the support structure, the second layer is between the third layer and the first layer, and the third layer is between the support structure and the second layer.

Example 5 provides the IC device of any one of the preceding examples, where the channel material has a recess, and the portion of the gate stack extending over the portion of the channel material is in the recess.

Example 6 provides the IC device of example 5, where the recess includes two sidewalls and a base, and the gate stack includes a gate dielectric material along the base and at least a portion of each of the two sidewalls.

Example 7 provides the IC device of example 6, where the gate stack further includes a gate electrode material within the recess, and the gate dielectric material is between the gate electrode material and the channel material.

Example 8 provides the IC device of example 7, where the gate dielectric material extends along each of the sidewalls to a top face of the channel material, and the gate electrode material extends above the top face of the channel material.

Example 9 provides the IC device of example 6, further including an insulator material above the gate electrode material and within the recess.

Example 10 provides the IC device of any one of the preceding examples, where the first distance is between about 20 and 400 nanometers, including all values and ranges therein, e.g., between about 40 and 60 nanometers.

Example 11 provides the IC device of any one of the preceding examples, where the second distance is between about 3 and 100 nanometers, including all values and ranges therein, e.g., between about 3 and 10 nanometers.

Example 12 provides the IC device of any one of examples 1-11, where the channel material is a thin film semiconductor material.

Example 13 provides the IC device of any one of examples 1-11, where the channel material is an epitaxial semiconductor material having a grain size between 2 nanometers and 100 nanometers.

Example 14 provides an IC device including a support structure; a channel material extending over the support structure, the channel material including a recess; a first S/D region in a portion of the channel material on one side of the recess; a second S/D region in a portion of the channel material on the other side of the recess; and a gate stack extending over the channel material through the recess, where a shortest path in the channel material, around the recess, between the first S/D region and the second S/D region is a non-straight line.

Example 15 provides the IC device of example 14, further including a capacitor coupled to the first S/D region, the capacitor and the first transistor forming a memory cell.

Example 16 provides the IC device of example 14 or 15, where the shortest path has a U shape around the recess.

Example 17 provides the IC device of any one of examples 14-16, where the recess has a first sidewall, a base, and a second sidewall, and the shortest path between the first S/D region and the second S/D region is in the channel material extending along the first sidewall, the base, and the second sidewall.

Example 18 provides the IC device of example 17, where the first S/D region is a first distance from the support structure, the base of the recess is a second distance from the support structure, and the second distance is less than the first distance.

Example 19 provides a method of fabricating IC device, the method including forming a channel material over a support structure, the channel material having a longitudinal structure extending in a direction parallel to an upper face the support structure; forming a first S/D region; forming a second S/D region; forming a recess in the channel material, where a bottom of the recess is at a first distance from the support structure that is less than a second distance between the first S/D region and the support structure; and forming a gate stack in the recess.

Example 20 provides the method of example 19, where forming the gate stack includes conformally depositing a layer of a gate dielectric material in the recess, and providing a gate electrode material in the recess so that the gate dielectric material is between the gate electrode material and the channel material.

Example 21 provides an IC device including a support structure having a top face and a bottom face, and a plurality of transistors over the support structure, a first of the plurality of transistors including a channel material having a recess therein; a first S/D region on a first side of the recess; a second S/D region on a second side of the recess opposite the first side; and a gate electrode extending through the recess in the channel material and physically and electrically coupled to a gate electrode of a second of the plurality of transistors.

Example 22 provides the IC device of example 21, further including a first contact to the first S/D region and a second contact to the second S/D region.

Example 23 provides the IC device of example 21 or 22, further including a capacitor coupled to the first S/D region, the capacitor and the first transistor forming a memory cell.

Example 24 provides the IC device of any one of examples 21-23, the channel material having a longitudinal structure extending in a first direction parallel to an upper face of the support structure, and the recess extending through the channel material in a second direction perpendicular to the first direction.

Example 25 provides the IC device of any one of examples 21-24, where the gate electrode of the first transistor and the gate electrode of the second transistor are electrically coupled to a word-line contact.

Example 26 provides an IC package that includes an IC die, including one or more of the memory/IC devices according to any one of the preceding examples. The IC package may also include a further component, coupled to the IC die.

Example 27 provides the IC package according to example 26, where the further component is one of a package substrate, a flexible substrate, or an interposer.

Example 28 provides the IC package according to examples 26 or 27, where the further component is coupled to the IC die via one or more first level interconnects.

Example 29 provides the IC package according to example 28, where the one or more first level interconnects include one or more solder bumps, solder posts, or bond wires.

Example 30 provides a computing device that includes a circuit board; and an IC die coupled to the circuit board, where the IC die includes one or more of the memory/IC devices according to any one of the preceding examples (e.g., memory/IC devices according to any one of examples 1-25), and/or the IC die is included in the IC package according to any one of the preceding examples (e.g., the IC package according to any one of examples 26-29).

Example 31 provides the computing device according to example 30, where the computing device is a wearable computing device (e.g., a smart watch) or hand-held computing device (e.g., a mobile phone).

Example 32 provides the computing device according to examples 30 or 31, where the computing device is a server processor.

Example 33 provides the computing device according to examples 30 or 31, where the computing device is a motherboard.

Example 34 provides the computing device according to any one of examples 30-33, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device comprising:
a support structure;
a channel material having a longitudinal structure extending in a direction parallel to the support structure;
a first source or drain (S/D) region at a first distance from the support structure;
a second S/D region; and
a gate stack having a portion over a portion of the channel material, where the portion of the gate stack over the portion of the channel material is at a second distance from the support structure, the second distance being smaller than the first distance.

2. The IC device of claim 1, further comprising:
a first contact coupled to the first S/D region; and
a second contact coupled to the second S/D region.

3. The IC device of claim 1 or 2, wherein:
the first S/D region and the second S/D region are in a first layer over the support structure,
the portion of the gate stack over the portion of the channel material is in a second layer over the support structure, and
the second layer is between the support structure and the first layer.

4. The IC device of claim 1 or 2, wherein:
the first S/D region is in a first layer over the support structure,
the portion of the gate stack over the portion of the channel material is in a second layer over the support structure,
the second S/D region is in a third layer over the support structure,
the second layer is between the third layer and the first layer, and
the third layer is between the support structure and the second layer.

5. The IC device of any of claims 1-4, wherein the channel material has a recess, and the portion of the gate stack extending over the portion of the channel material is in the recess.

6. The IC device of claim 5, wherein the recess comprises two sidewalls and a base, and the gate stack comprises a gate dielectric material along the base and at least a portion of each of the two sidewalls.

7. The IC device of claim 6, wherein the gate stack further comprises a gate electrode material within the recess, where the gate dielectric material is between the gate electrode material and the channel material.

8. The IC device of claim 7, wherein the gate dielectric material extends along each of the sidewalls to a top face of the channel material, and the gate electrode material extends above the top face of the channel material.

9. The IC device of claim 7, further comprising an insulator material above the gate electrode material and within the recess.

10. The IC device of any of claims 1-9, wherein the first distance is between about 20 and 400 nanometers.

11. The IC device of any of claims 1-10, wherein the second distance is between about 3 and 100 nanometers.

12. The IC device of any of claims 1-11, wherein the channel material is a thin film semiconductor material.

13. The IC device of any of claims 1-11, wherein the channel material is an epitaxial semiconductor material having a grain size between 2 nanometers and 100 nanometers.

14. A method of fabricating an integrated circuit (IC) device, the method comprising:
forming a channel material over a support structure, the channel material having a longitudinal structure extending in a direction parallel to an upper face the support structure;
forming a first source or drain (S/D) region;
forming a second S/D region;
forming a recess in the channel material, wherein a bottom of the recess is at a first distance from the support structure that is less than a second distance between the first S/D region and the support structure; and
forming a gate stack in the recess.

15. The method of claim 14, wherein forming the gate stack comprises:
conformally depositing a layer of a gate dielectric material in the recess; and providing a gate electrode material in the recess so that the gate dielectric material is between the gate electrode material and the channel material.
